Europäisches Patentamt

European Patent Office

Office européen des brevets

(11) Publication number: **0 388 490 B1**

## EUROPEAN PATENT SPECIFICATION

(45) Date of publication of patent specification: **09.03.94**　(51) Int. Cl.⁵: **H03G 3/20,** H03G 7/06

(21) Application number: **89105076.7**

(22) Date of filing: **21.03.89**

(54) **Level control circuits.**

(43) Date of publication of application:
**26.09.90 Bulletin 90/39**

(45) Publication of the grant of the patent:
**09.03.94 Bulletin 94/10**

(84) Designated Contracting States:
**DE FR GB NL**

(56) References cited:
WO-A-84/01244　　FR-A- 2 384 384
GB-A- 2 073 518　　US-A- 3 824 584
US-A- 3 995 178　　US-A- 4 204 171

(73) Proprietor: **SONY CORPORATION**
**7-35 Kitashinagawa 6-chome**
**Shinagawa-ku**
**Tokyo 141(JP)**

(72) Inventor: **Yokoya, Satoshi**
**c/o Sony Corporation**
**7-35 Kitashinagawa 6-chome**
**Shinagawa-ku Tokyo(JP)**

(74) Representative: **TER MEER - MÜLLER - STEIN-**
**MEISTER & PARTNER**
**Mauerkircherstrasse 45**
**D-81679 München (DE)**

## Description

### Field of the Invention

The present invention relates generally to level control circuits for producing substantially level-controlled signals, and more particularly, is directed to improvements in a circuit which is supplied with an input signal and a control voltage produces an output signal corresponding to a level-controlled input signal.

### Description of the Prior Art

A level control circuit used for constituting a compressor for compressing the level of an audio signal or an expander for expanding the level of an audio signal has been usually embodied in the form of a voltage controlled variable gain amplifier which comprises a bipolar transistor. In the voltage controlled variable gain amplifier comprising the bipolar transistor, such an $I_E$ - $V_{BE}$ characteristic of the bipolar transistor that a relation between an emitter current ($I_E$) and a base-emitter voltage ($V_{BE}$) is expressed by the equation:

$$I_E = I_S(e^{q \cdot V_{BE}/k \cdot T} - 1),$$

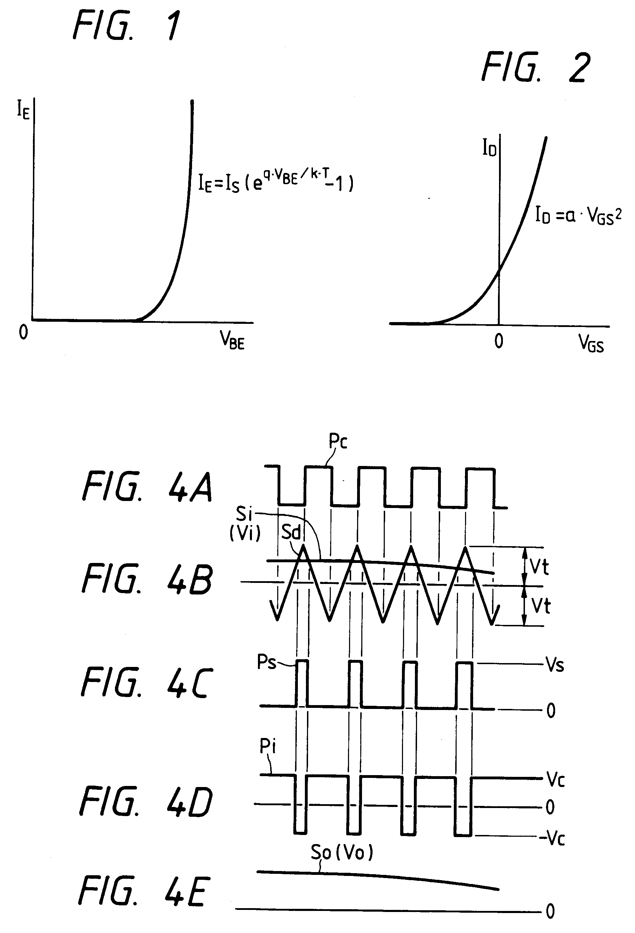

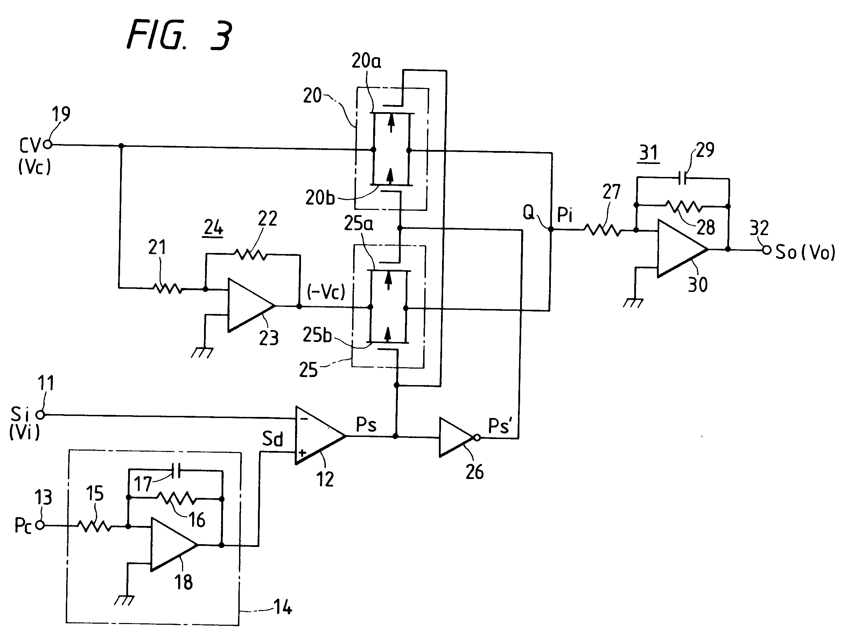

where $I_S$ represents a saturation current, $q$ represents electron charge, $k$ represents the Boltzmann's constant and $T$ represents absolute temperature, and therefore the emitter current $I_E$ varies exponentially to variations of the base-emitter voltage $V_{BE}$, as shown in Fig. 1, is utilized, so that a gain control is conducted based on the fact that mutual conductance ($gm$) is in proportion to the emitter current $I_E$ in the case of the bipolar transistor and an output signal of the voltage controlled variable gain amplifier is controlled in level to vary with superior linearity in control in response to a control voltage which is applied to the bipolar transistor to cause variations in the emitter current $I_E$ thereof.

On the other hand, a circuit employed in an audio signal recording and reproducing apparatus, a telephone set or the like for processing audio signals is desired to be integrated by the use of MOS field effect transistors in view of coexistence with other circuits and large scale integration because the MOS field effect transistor, referred to a MOS FET hereinafter, is a typical insulated gate field effect transistor and the circuit configuration composed mainly of the MOS FETs can be integrated more easily than a circuit configuration composed mainly of the bipolar transistors and is so advantagious for integration.

In the case where the circuit operative to process the audio signal is formed into an integrated circuit structure using the MOS FETs, each of active portions is composed of the MOS FETs in place of the bipolar transistors. On that occasion, if a level control circuit which is contained in the integrated circuit structure so as to constitute a compressor for compressing the level of the audio signal or an expander for expanding the level of the audio signal is provided in the form of a voltage controlled variable gain amplifier which comprises the MOS FET with the same configuration as the voltage controlled variable gain amplifier comprising the bipolar transistor, a problem that an output signal of the level control circuit cannot be controlled in level to vary with superior linearity in control in response to a control voltage applied to the MOS FET is brought about for the reason mentioned below.

The MOS FET has such an $I_D$ - $V_{GS}$ characteristic that a relation between a drain current ($I_D$) and a gate-source voltage ($V_{GS}$) is expressed by the equation: $I_D = a \cdot V_{GS}^2$, where $a$ is a constant, and therefore the drain current $I_D$ varies in accordance with a square characteristic to variations of the gate-source voltage $V_{GS}$, as shown in Fig. 2. Therefore, in the case of the voltage controlled variable gain amplifier comprising the MOS FET, nonlinear variations in gain are obtained in response to variations in the drain current $I_D$ which are caused by the control voltage applied to the MOS FET, and consequently, the output signal controlled in level to vary with superior linearity in control in response to the control voltage cannot be obtained.

FR-A- 2 384 384 discloses a level control circuit including MOS FET switching means wherein the level depends on the duty cycle of the control signal.

### OBJECTS AND SUMMARY OF THE INVENTION

Accordingly, it is an object of the present invention to provide a level control circuit to which an input signal and a control signal are supplied to produce an output signal corresponding to a level-controlled input signal and which avoids the aforementioned problem encountered with the prior art.

Another object of the present invention is to provide a level control circuit to which an input signal and a control signal are supplied to produce an output signal corresponding to a level-controlled input signal and which causes the output signal to vary in level with superior linearity in control in response to the control signal with a relatively simple configuration fitting for integration.

A further object of the present invention is to provide a level control circuit to which an input signal and a control signal are supplied to produce an output signal corresponding to a level-controlled input signal and which comprises MOS FETs to have its configuration advantageous for integration and causes the output signal to vary in level with superior linearity in control in response to the control voltage.

According to the present invention, there is provided a level control circuit comprising a level comparing portion for comparing in level an input signal with a triangular or saw-toothed waveform voltage signal having a frequency sufficiently higher than that of the input signal to produce a pulse-width modulated signal varying in response to variations in a level of the input signal, a pulse voltage generating portion including a switching portion controlled to have turning operations by the pulse-width modulated signal obtained from the level comparing portion and being operative to generate, in response to the turning operations of the switching portion, a pulse voltage signal having one of negative and positive levels obtained in accordance with a level of a control voltage supplied thereto for the duration of each high level part of the pulse-width modulated signal and the other of the negative and positive levels for the duration of each low level part of the pulse-width modulated signal, and a low pass filter portion for extracting relatively low frequency components of the pulse voltage signal generated by the pulse voltage generating portion so as to produce an output signal which corresponds to the input signal level-controlled in accordance with the control voltage.

In the level control circuit thus constituted in accordance with the present invention, the pulse-width modulated signal is obtained from the level comparing portion as a pulse train signal containing pulses each having its width corresponding to the level of the input signal, and the pulse voltage signal which is composed, for example, of a part of voltage obtained by means of inverting in polarity the control voltage in the duration of each pulse of the pulse-width modulated and a part of the control voltage in the duration of each period between each two successive pulses of the pulse-width modulating signal so as to have the negative and positive levels alternately, is obtained from the pulse voltage generating portion. The pulse voltage signal thus obtained from the pulse voltage generating portion corresponds to a pulse train signal obtained by means of converting the level of the pulse-width modulated signal from the level comparing portion in accordance with the level of the control voltage. Then, the pulse voltage signal from the pulse voltage generating portion is supplied to the low pass filter portion to produce the output signal which is composed of the relatively low frequency components of the pulse voltage signal extracted by the low pass filter portion. The output signal from the low pass filter portion corresponds to a signal obtained by means of varying the level of the input signal in accordance with the control voltage, that is, the input signal level-controlled in accordance with the control voltage. This results in that the output signal is obtained by means of causing the input signal to have its level varying in proportion to the level of the control voltage at the output of the low pass filter portion and therefore a level-controlling operation is carried out with superior linearity in control.

Further, in the case where each of the level comparing portion, pulse voltage generating portion, low pass filter portion and so on comprises an operational amplifier and the switching portion included in the pulse voltage generating portion is composed of MOS FETs, as practiced as an embodiment, the level control circuit according to the present invention is especially advantageous for being incorporated with an integrated circuit structure constituted by the use of MOS FETs.

The above, and other objects, features and advantages of the present invention will become apparent from the following detailed description which is to be read in conjunction with the accompanying drawings.

## BRIEF DESCRIPTION OF THE DRAWINGS

Fig. 1 is a graphic illustration showing the characteristic of a bipolar transistor;

Fig. 2 is a graphic illustration showing the characteristic of a MOS FET;

Fig. 3 is a schematic block diagram showing an embodiment of level control circuit according to the present invention;

Figs. 4A to 4E are waveform diagrams used for explaining the operation of the embodiment shown in Fig. 3; and

Fig. 5 is a schematic block diagram showing another embodiment of level control circuit according to the present invention.

## DESCRIPTION OF THE PREFERRED EMBODIMENTS

Fig. 3 shows an embodiment of level control circuit according to the present invention.

Referring to Fig. 3, an input signal Si, such as an audio signal, is supplied through an input terminal 11 to one of input ends of a level comparator 12. Further, a clock pulse signal Pc having a constant amplitude at frequency of 400kHz which is sufficiently higher than the frequency of the input signal Si, as shown in Fig. 4A, is supplied through an input terminal 13 to a Miller integrator 14. The Miller integrator 14 comprises an operational amplifier 18 having a first input end connected through a resistor 15 to the input terminal 13, a second input end grounded, and an output end coupled through a parallel connection of a resistor 16 and a capacitor 17 to the first input end.

When the clock pulse signal Pc from the input terminal 13 is supplied through the resistor 15 to the first input end of the operational amplifier 18, a triangular waveform voltage signal Sd having an amplitude 2Vt (peak-to -peak value) and a period corresponding to the period of the clock pulse signal Pc, as shown in Fig. 4B, is obtained at the output end of the operational amplifier 18, which forms an output terminal of the Miller integrator 14, and supplied to the other of the input ends of the level comparator 12.

A level Vi of the input signal Si is compared with the level of the triangular waveform voltage signal Sd in the level comparator 12 and a signal containing pulses each appearing with a constant level Vs when the level Vi of the input signal Si is lower than the level of the triangular waveform voltage signal Sd, that is, a pulse-width modulated signal Ps containing pulses each having its width corresponding to the level Vi of the input signal Si, as shown in Fig. 4C, is obtained at an output end of the level comparator 12.

A control voltage CV having a level Vc is supplied to an input terminal 19. This control voltage CV is supplied directly to a first switching device 20 as a first voltage and supplied also to a polarity inverter 24 which comprises an operational amplifier 23 having a first input end connected through a resistor 21 to the input terminal 19, a second input end grounded, and an output end coupled through a resistor 22 to the first input end. The polarity inverter 24 inverts in polarity the control voltage CV to produce a second voltage having a level -Vc and supplies a second switching device 25 with the second voltage.

The first switching device 20 is composed of a MOS FET 20a of the N channel type and a MOS FET 20b of the P channel type. Drain-source paths of the MOS FETs 20a and 20b are connected in parallel to each other and the first voltage is applied to a connecting point between the drains or the sources of the MOS FETs 20a and 20b. Similarly, the second switching device 25 is composed of a MOS FET 25a of the N channel type and a MOS FET 25b of the P channel type. Drain-source paths of the MOS FETs 25a and 25b are connected in parallel to each other and the second voltage is applied to a connecting point between the drains or the sources of the MOS FETs 25a and 25b. A connecting point between the sources or the drains of the MOS FETs 20a and 20b and a connecting point between the sources or the drains of the MOS FETs 25a and 25b are coupled with a connecting point Q in common.

With such an arrangement, the pulse-width modulated signal Ps obtained from the level comparator 12 is supplied to both a gate of the MOS FETs 20a constituting the first switching device 20 and a gate of the MOS FETs 25b constituting the second switching device 25, so that the MOS FET 20a is caused to be nonconductive and the MOS FET 25b is caused to be conductive for the duration of each pulse having the level Vs of the pulse-width modulated signal Ps and the MOS FET 20a is caused to be conductive and the MOS FET 25b is caused to be nonconductive for the duration of a period between each two successive pulses of the pulse-width modulated signal Ps. Further, an inverted pulse-width modulated signal Ps' which is obtained from a polarity inverter 26 provided for inverting in polarity the pulse-width modulated signal Ps is supplied to both a gate of the MOS FET 20b constituting the first switching device 20 and a gate of the MOS FET 25a constituting the second switching device 25, so that the MOS FET 20b is caused to be conductive and the MOS FET 25a is caused to be nonconductive for the duration of each pulse having the level Vs of the inverted pulse-width modulated signal Ps' and the MOS FET 20b is caused to be nonconductive and the MOS FET 25a is caused to be conductive for the duration of a period between each two successive pulses of the inverted pulse-width modulated signal Ps'.

With such a switching operation in which each of the first and second switching devices 20 and 25 is turned on and off alternately in response to the pulse-width modulated signal Ps, the second voltage which is obtained with the level -Vc from the polarity inverter 24 provided for inverting in polarity the control voltage CV is derived to the connecting point Q from the second switching device 25 for the duration of each pulse of the pulse-width modulated signal Ps, that is, for the duration of the period between each two successive pulses of the inverted pulse-width modulated signal Ps' and the first voltage which is identical with the control voltage CV having the level Vc is derived to the connecting point Q from the first switching device 20 for the duration of the period between each two successive pulses of the pulse-width modulated signal Ps, that is, for the duration of each pulse of the inverted pulse-width modulated signal Ps'. As a result, a pulse voltage signal Pi which has the level -Vc for the duration of each pulse of the pulse-width modulated signal Ps and the level Vc for the duration of the period between each two successive pulses of the pulse-width modulated signal Ps, as shown in Fig. 4D, is obtained at the connecting point Q. The pulse voltage signal Pi obtained at the connecting point Q corresponds to a pulse train signal obtained by means of converting the level $Vs$ of the pulse-width modulated signal $Ps$ in accordance with the level $Vc$ of the control voltage $CV$.

The pulse voltage signal $Pi$ appearing at the connecting point $Q$ is supplied to a low pass filter 31 which comprises an operational amplifier 30 having a first input end connected through a resistor 27 to the connecting point $Q$, a second input end grounded, and an output end coupled through a parallel connection of a resistor 28 and a capacitor 29 to the first input end. The low pass filter 31 has a cutoff frequency sufficiently lower than the frequency of the clock pulse signal $Pc$ and is operative to permit relatively low frequency components of the pulse voltage signal $Pi$ to path therethrough. Therefore, an output signal $So$ having a level $Vo$ which obtained as a product of the level $Vc$ of the control voltage $CV$ and a ratio of the level $Vi$ of the input signal $Si$ to a half of the amplitude $2Vt$ of the triangular waveform voltage signal $Sd$, and represented by $Vc \cdot Vi/Vt$, as shown in Fig. 4E, is obtained at an output terminal 32 connected to the output end of the low pass filter 31. The level $Vo$ of the output signal $So$ varies in response to variations in the level $Vi$ of the input signal $Si$ and also in proportion to the level $Vc$ of the control voltage $CV$. Accordingly, the output signal $So$ is produced to correspond to a signal obtained by means of controlling the level $Vi$ of the input signal $Si$ to vary in proportion to the control voltage $CV$ and this results in that a level-controlling operation to the input signal $Si$ is carried out with superior linearity in control in accordance with the control voltage $CV$.

In the embodiment described above, each of the level comparator 12, operational amplifiers 18, 23 and 30, and polarity inverter 26 is constituted, for example, by the use of MOS FETs. Further, although the triangular waveform voltage signal $Sd$ is obtained from the Miller integrator 14 and the input signal $Si$ is compared in level with the triangular waveform voltage signal $Sd$ in the level comparator 12 in the embodiment shown in Fig. 3, it is possible to use a saw-toothed waveform voltage signal for level comparison with the input signal $Si$ in the level comparator 12, in place of the triangular waveform voltage signal $Sd$.

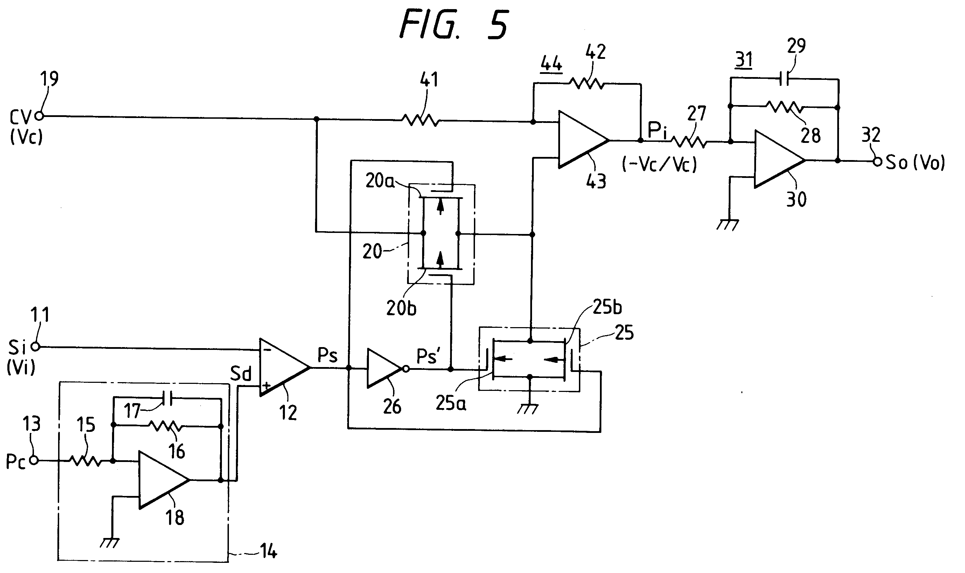

Fig. 5 shows another embodiment of level control circuit according to the present invention. In Fig. 5, elements, devices and parts corresponding to those of Fig. 3 are marked with the same references and further description thereof will be omitted.

Referring to Fig. 5, an input signal $Si$ having a level $Vi$ and a clock pulse signal $Pc$ are supplied through input terminals 11 and 13 to a level comparator 12 and a Miller integrator 14, respectively, in the same manner as those in the embodiment shown in Fig. 3. A control voltage $CV$ having a level $Vc$ is supplied through an input terminal 19 and a resistor 41 to a first input end of an operational amplifier 43 which is provided with a resistor 42 connected between the first input end and an output end thereof, and supplied directly to a connecting point between drains or sources of a MOS FET 20a of the N channel type and a MOS FET 20b of the P channel type constituting a first switching device 20. A second input end of the operational amplifier 43 is connected to a connecting point between sources or drains of the MOS FET 20a and the MOS FET 20b constituting the first switching device 20 and also to a connecting point between drains or sources of a MOS FET 25a of the N channel type and a MOS FET 25b of the P channel type constituting a second switching device 25. A connecting point between sources or drains of the MOS FET 25a the MOS FET 25b constituting the second switching device 25 is grounded.

The output end of the operational amplifier 43 is coupled with a low pass filter 31 which comprises an operational amplifier 30 connected thorough a resistor 27 to the output end of the operational amplifier 43.

Other portions of the embodiment shown in Fig. 5 are constituted in the same manner as respective corresponding portions of the embodiment shown in Fig. 3 and aforementioned.

With such an arrangement, a pulse-width modulated signal $Ps$ obtained from the level comparator 12, as shown in Fig. 4A, is supplied to gates of the MOS FETs 20a and 25b and an inverted pulse-width modulated signal $Ps'$ obtained from a polarity inverter 26 are supplied to gates of the MOS FETs 20b and 25a for turning the first and second switches 20 and 25 on and off in such a manner as described above.

When each of the MOS FETs 20a and 20b constituting the first switching device 20 is caused to be nonconductive so as to turn the first switching device 20 off and each of the MOS FETs 25a and 25b constituting the second switching device 25 is caused to be conductive so as to turn the second switching device 25 on for the duration of each pulse of the pulse-width modulated signal $Ps$, the second input end of the operational amplifier 43 is isolated from the input terminal 19 by the first switching device 20 and grounded through the second switching device 25. Accordingly, the operational amplifier 43 forms a polarity inverter for the control voltage $CV$ and produces a voltage $-CV$ having a level $-Vc$ at the output end thereof by inverting the control voltage $CV$ supplied through the resistor 41 to the first input end thereof.

On the other hand, when each of the MOS FETs 20a and 20b constituting the first switching device 20 is caused to be conductive so as to turn the first switching device 20 on and each of the MOS FETs 25a and 25b constituting the second switching device 25 is caused to be nonconductive so as to turn the second switching device 25 off for the duration of a period between each two successive pulses of the pulse-width modulated signal Ps, the second input end of the operational amplifier 43 is conducted through the first switching device 20 to the input terminal 19 and isolated from the ground by the second switching device 25. Accordingly, the operational amplifier 43 forms a voltage follower circuit for the control voltage CV and the control voltage CV which is supplied through the second switching device 25 to the second input end of the operational amplifier 43 is transmitted to the output end of the operational amplifier 43.

As a result of the operation of the operational amplifier 43 as described above, a pulse voltage signal Pi which has the level -Vc for the duration of each pulse of the pulse-width modulated signal Ps and the level Vc for the duration of the period between each two successive pulses of the pulse-width modulated signal Ps, as shown in Fig. 4D, is obtained at the output end of the operational amplifier 43.

In such a manner, the resistors 41 and 42, operational amplifier 43, first and second switching devices 20 and 25 and polarity inverter 26 inclusive constitute a pulse voltage generator 44, and the pulse voltage signal Pi thus obtained corresponds to a pulse train signal obtained by means of converting the level Vs of the pulse-width modulated signal Ps in accordance with the level Vc of the control voltage CV.

The pulse voltage signal Pi produced by the pulse voltage generator 44 is supplied to the low pass filter 31 and an output signal So having a level Vo which varies in response to variations in the level Vi of the input signal Si and also in proportion to the level Vc of the control voltage CV is obtained at an output terminal 32 connected to the low pass filter 31 in the same manner as that in the embodiment shown in Fig. 3.

In the embodiment shown in Fig. 5, the same merits and advantages as those obtained in the embodiment shown in Fig. 3 can be obtained also and, in addition, a level-controlling operation can be carried out more precisely compared with the level-controlling operation in the embodiment shown in Fig. 3

In the embodiment shown in Fig. 5 also, each of the level comparator 12, operational amplifiers 18, 30 and 43, and polarity inverter 26 is constituted, for example, by the use of MOS FETs. Further, it is possible to use a saw-toothed waveform voltage signal for level comparison with the input signal Si in the level comparator 12, in place of the triangular waveform voltage signal Sd.

## Claims

1. A level control circuit comprising:

    level comparing means (12-18) for comparing in level an input signal (Si) with a triangular or saw-toothed waveform voltage signal having a frequency sufficiently higher than that of the input signal to produce a pulse-width modulated signal (Ps) varying in response to variations in level of the input signal,

    pulse voltage generating means (20-25) including switching means (20, 25) controlled to have turning operations by said pulse-width modulated signal obtained from the level comparing means and operative to generate, in response to the turning operations of said switching means, a pulse voltage signal (Pi) having one of negative and positive levels obtained in accordance with a level of a control voltage supplied to said pulse voltage generating means for the duration of each high level part of the pulse-width modulated signal and the other of said negative and positive levels for the duration of each low level part of the pulse-width modulated signal, and

    low pass filter means (31) for extracting relatively low frequency components fo the pulse voltage signal generated by said pulse voltage generating means so as to produce an output signal (So) which corresponds to the input signal (Si) level-controlled in accordance with the control voltage.

2. A level control circuit according to claim 1, wherein said level comparing means (12-18) comprises signal generating means (14) for producing said triangular or saw-toothed waveform voltage signal based on a clock pulse signal (Pc) supplied to said level comparing means (14) and a comparator (12) supplied with both the input signal (Si) and said triangular or saw-toothed waveform voltage signal (Sd) produced by the signal generating means (14).

3. A level control circuit according to claim 2, wherein said signal generating means comprises a Miller integrator (15-18) to which the clock pulse signal (Pc) is supplied.

4. A level control circuit according to claim 1, wherein said switching means (20, 25) included in the pulse voltage generating means comprises first (20) and second switching devices (25) driven to be turned on and off alternately by said pulsed-width modulated signal (Ps)

obtained from the level comparing means (12-18).

5. A level control circuit according to claim 4, wherein said pulse voltage generating means (20-25) comprises further polarity inverting means (24) for inverting in polarity said control voltage (Vc) to produce an inverted control voltage (-Vc) and is so arranged that said first switching device (20) is supplied with said control voltage (Vc), said second switching device (25) is supplied with said inverted control voltage (-Vc) obtained from the polarity inverting means (24), and outputs of said first and second switching devices (20, 25) are mixed with each other to produce said pulse voltage signal (Pi).

6. A level control circuit according to claim 5, wherein said first switching device (20) comprises a first MOS field effect transistor (20a) having its drain-source path connected to be supplied with said control voltage (Vc) and its gate connected to said level comparing means (12-18) and said second switching device (25) comprises a second MOS field effect transistor (25a) having its drain-source path connected to be supplied with said inverted control voltage (-Vc) and its gate connected to said level comparing means (12-18).

7. A level control circuit according to claim 6, wherein said first switching device (20) further comprises a third MOS field effect transistor (20b) different in type from said first MOS field effect transistor (20a) and having its drain-source path connected in parallel with the drain-source path of said first field effect transistor and its gate connected to said level comparing means (12-18), and said second switching device (25) further comprises a fourth MOS field effect transistor different (25b) in type from said second MOS field effect transistor (25a) and having its drain-source path connected in parallel with the drain-source path of said second field effect transistor (25a) and its gate connected to said level comparing means (12-18).

8. A level control circuit according to claim 4, wherein said pulse voltage generating means comprises further operational amplifier means (44) having first and second input ends and an output end and is so arranged that said first switching device (20) is connected between the first and second input ends of said operational amplifier means, the second switching device (25) is connected between the second input end of said operational amplifier means (44) and the ground, each of the first input end of said operational amplifier (44) and said first switching means (20) is supplied with the control voltage (Vc), and the output (Pi) end of said operational amplifier means supplies said low pass filter means (31) with said pulse voltage signal.

9. A level control circuit according to claim 8, wherein said first switching device comprises a first MOS field effect transistor (20a) having its drain-source path connected between the first and second input ends of said operational amplifier means (44) and its gate connected to said level comparing means (12-18) and said second switching device (25) comprises a second MOS field effect transistor (25a) having its drain-source path connected between the second input end of said operational amplifier means (44) and the ground and its gate connected so said level comparing means (12-18).

10. A level control circuit according to claim 9, wherein said first switching device (20) further comprises a third MOS field effect transistor (20b) different in type from said first MOS field effect transistor (20a) and having its drain-source path connected in parallel with the drain-source path of said first field effect transistor (20a) and its gate connected to said level comparing means (12-18), and said second switching device (25) further comprises a fourth MOS field effect transistor (25b) different in type from said second MOS field effect transistor (25a) and having its drain-source path connected in parallel with the drain-source path of said second MOS field effect transistor (25a) and its gate connected to said level comparing means (12-18).

11. A level control circuit according to claim 1, wherein each of said level comparing means (12-18), said pulse voltage generating means (20-25) and said low pass filter means (31) is constituted mainly by MOS field effect transistors.

**Patentansprüche**

1. Pegelsteuerungsschaltung mit:
   - einer Pegelvergleichseinrichtung (12-18) zum pegelmäßigen Vergleichen eines Eingangssignals (Si) mit einem Dreieck- oder Sägezahnspannungssignal mit einer Frequenz, die ausreichend höher als diejenige des Eingangssignals ist, um ein impulsbreitenmoduliertes Signal (Ps) zu erzeugen, das sich abhängig von Pegeländerungen des Eingangssignals ändert;

- einer Impulsspannung-Erzeugungsein-richtung (20-25) mit Umschalteinrichtun-gen (20, 25), die so gesteuert werden, daß sie Umschaltvorgänge durch das von der Pegelvergleichsschaltung erhaltene impulsbreitenmodulierte Signal ausführen, und die so arbeitet, daß sie auf die Umschaltvorgänge der Umschalteinrichtungen hin ein Impulsspannungssignal (Pi), negativen oder positiven Pegels erzeugt, der abhängig vom Pegel einer der Impulsspannung-Erzeugungseinrichtung zugeführten Steuerspannung für die Dauer jedes Teils hohen Pegels des impulsbreitenmodulierten Signals erhalten wird, und den anderen der negativen und positiven Pegel für die Dauer jedes Teils niedrigen Pegels des impulsbreitenmodulierten Signals aufweist; und

- einer Tiefpaßfiltereinrichtung (31) zum Entnehmen von Komponenten relativ niedriger Frequenz fo des von der Im-pulsspannung-Erzeugungseinrichtung er-zeugten Impulsspannungssignals, um ein Ausgangssignal (So) zu erzeugen, das dem abhängig von der Steuerspannung im Pegel gesteuerten Eingangssignal (Si) entspricht.

2. Pegelsteuerungsschaltung nach Anspruch 1, bei der die Pegelvergleichseinrichtung (12-18) eine Signalerzeugungseinrichtung (14) zum Er-zeugen des Dreieck- oder Sägezahnspan-nungssignals auf Grundlage eines der Pegel-vergleichseinrichtung (14) zugeführten Taktim-pulssignals (Pc), sowie einen Komparator (12) aufweist, der sowohl mit dem Eingangssignal (Si) als auch dem von der Signalerzeugungseinrichtung (14) erzeugten Dreieck- oder Sägezahnspannungssignal (Sd) versorgt wird.

3. Pegelsteuerungsschaltung nach Anspruch 2, bei der die Signalerzeugungseinrichtung einen Miller-Integrator (15-18) aufweist, dem das Taktimpulssignal (Pc) zugeführt wird.

4. Pegelsteuerungsschaltung nach Anspruch 1, bei der die Umschalteinrichtungen (20, 25) in der Impulsspannung-Erzeugungseinrichtung eine erste (20) und eine zweite Umschalteinrichtung (25) beinhalten, die von dem von der Pegelvergleichseinrichtung (12-18) erhaltenen impulsbreitenmodulierten Signal (Ps) so betrieben werden, daß sie abwechselnd ein- und ausgeschaltet werden.

5. Pegelsteuerungsschaltung nach Anspruch 4, bei der die Impulsspannung-Erzeugungseinrichtung (20-25) ferner einen Polaritätsinverter (24) zum Invertieren der Polarität der Steuerspannung (Vc) aufweist, um eine invertierte Steuerspannung (-Vc) zu erzeugen, und sie so ausgebildet ist, daß die erste Umschalteinrichtung (20) mit der Steuerspannung (Vc), die zweite Umschalteinrichtung (25) mit der von der Polaritätsinvertereinrichtung (24) erhaltenen invertierten Steuerspannung (-Vc) versorgt wird, und die Ausgangssignale der ersten und der zweiten Umschalteinrichtung (20, 25) miteinander gemischt werden, um das Impulsspannungssignal (Pi) zu erzeugen.

6. Pegelsteuerungsschaltung nach Anspruch 5, bei der die erste Umschalteinrichtung (20) einen ersten MOS-Feldeffekt-Transistor (20a) aufweist, dessen Drain/Source-Pfad so angeschlossen ist, daß er mit der Steuerspannung (Vc) versorgt wird, und dessen Gate mit der Pegelvergleichseinrichtung (12-18) verbunden ist, und die zweite Umschalteinrichtung (25) einen zweiten MOS-Feldeffekttransistor (25a) aufweist, dessen Drain/Source-Pfad so angeschlossen ist daß er mit der invertierten Steuerspannung (-Vc) versorgt wird, und dessen Gate mit der Pegelvergleichseinrichtung (12-18) verbunden ist.

7. Pegelsteuerungsschaltung nach Anspruch 6, bei der die erste Umschalteinrichtung (20) ferner einen dritten MOS-Feldeffekttransistor (20b) von anderem Typ als der erste MOS-Feldeffekttransistor (20a) aufweist, dessen Drain/Source-Pfad parallel zum Drain/Source-Pfad des ersten Feldeffekttransistors geschaltet ist, und dessen Gate mit der Pegelvergleichseinrichtung (12-18) verbunden ist, und die zweite Umschalteinrichtung (25) ferner einen vierten MOS-Feldeffekttransistor (25b) von anderem Typ als der zweite MOS-Feldeffekttransistor (25a) aufweist, dessen Drain/Source-Pfad parallel zum Drain/Source-Pfad des zweiten Feldeffekttransistors (25a) geschaltet ist, und dessen Gate mit der Pegelvergleichseinrichtung (12-18) verbunden ist.

8. Pegelsteuerungsschaltung nach Anspruch 4, bei der die Impulsspannung-Erzeugungsein-richtung ferner eine Operationsverstärkerein-richtung (44) mit einem ersten und einem zweiten Eingangsende und einem Ausgangsende aufweist, und sie so ausgebildet ist, daß die erste Umschalteinrichtung (20) zwischen das erste und zweite Eingangsende der Operationsverstärkereinrichtung geschaltet ist, die

zweite Umschalteinrichtung (25) zwischen das zweite Eingangsende der Operationsverstärkereinrichtung (44) und Masse geschaltet ist, wobei das erste Eingangsende des Operationsverstärkers (44) und die erste Umschalteinrichtung (20) beide mit der Steuerspannung (Vc) versorgt werden, und das Ausgangsende (Pi) der Operationsverstärkereinrichtung die Tiefpaßfiltereinrichtung (31) mit dem Impulsspannungssignal versorgt.

9. Pegelsteuerungsschaltung nach Anspruch 8, bei der die erste Umschalteinrichtung einen ersten MOS-Feldeffekttransistor (20a) aufweist, dessen Drain/Source-Pfad zwischen das erste und das zweite Eingangsende der Operationsverstärkereinrichtung (44) geschaltet ist, und dessen Gate an die Pegelvergleichseinrichtung (12-18) angeschlossen ist, und die zweite Umschalteinrichtung (25) einen zweiten MOS-Feldeffekttransistor (25a) aufweist, dessen Drain/Source-Pfad zwischen das zweite Eingangsende der Operationsverstärkereinrichtung (44) und Masse geschaltet ist, und dessen Gate mit der Pegelvergleichseinrichtung (12-18) verbunden ist.

10. Pegelsteuerungsschaltung nach Anspruch 9, bei der die erste Umschalteinrichtung (20) ferner einen dritten MOS-Feldeffekttransistor (20b) von anderem Typ als der erste MOS-Feldeffekttransistor (20a) aufweist, dessen Drain/Source-Pfad parallel zum Drain/Source-Pfad des ersten Feldeffekttransistors (20a) geschaltet ist, und dessen Gate mit der Pegelvergleichseinrichtung (12-18) verbunden ist, und die zweite Umschalteinrichtung (25) ferner einen vierten MOS-Feldeffekttransistor (25b) von anderem Typ als der zweite MOS-Feldeffekttransistor (25a) aufweist, dessen Drain/Source-Pfad parallel zum Drain/Source-Pfad des zweiten MOS-Feldeffekttransistors (25a) geschaltet ist, und dessen Gate mit der Pegelvergleichseinrichtung (12-18) verbunden ist.

11. Pegelsteuerungsschaltung nach Anspruch 1, bei der die Pegelvergleichseinrichtung (12-18), die Impulsspannung-Erzeugungseinrichtung (20-25) und die Tiefpaßfiltereinrichtung (31) jeweils hauptsächlich durch MOS-Feldeffektransistoren gebildet werden.

**Revendications**

1. Circuit de commande de niveau comprenant :
   un moyen de comparaison de niveau (12 à 18) pour comparer en niveau un signal d'entrée (Si) à un signal de tension de forme d'onde triangulaire ou en dent de scie ayant une fréquence suffisamment plus élevée que celle du signal d'entrée pour produire un signal modulé par largeur d'impulsion (Ps) variant en réponse aux variations de niveau du signal d'entrée ;
   un moyen générateur de tension impulsionnelle (20 à 25) incluant un moyen de commutation (20, 25) commandé, pour subir des opérations de basculement, par ledit signal modulé par largeur d'impulsion obtenu à partir du moyen de comparaison de niveau et servant à produire, en réponse aux opérations de basculement dudit moyen de commutation, un signal de tension impulsionnelle (Pi) ayant l'un des niveaux négatif et positif, obtenus en fonction du niveau d'une tension de commande délivrée audit moyen générateur de tension impulsionnelle pendant la durée de chaque partie de niveau haut du signal modulé par largeur d'impulsion, et l'autre desdits niveaux négatif et positif pendant la durée de chaque partie de niveau bas du signal modulé par largeur d'impulsion ; et,
   un moyen formant filtre passe-bas (31) pour extraire les composantes de fréquences relativement basses du signal de tension impulsionnelle produit par ledit moyen générateur de tension impulsionnelle de manière à produire un signal de sortie (So), qui correspond au signal d'entrée (Si), commandé en niveau en fonction de la tension de commande.

2. Circuit de commande de niveau selon la revendication 1, dans lequel ledit moyen de comparaison de niveau (12 à 18) comprend un moyen générateur de signal (14) pour produire ledit signal de tension de forme d'onde triangulaire ou en dent de scie en se basant sur un signal impulsionnel d'horloge (Pc), délivré audit moyen de comparaison de niveau (14) et un comparateur (12) alimenté avec à la fois le signal d'entrée (Si) et ledit signal de tension de forme d'onde triangulaire ou en dent de scie (Sd) produit par le moyen générateur de signal (14).

3. Circuit de commande de niveau selon la revendication 2, dans lequel ledit moyen générateur de signal comprend un intégrateur de Miller (15 à 18) auquel le signal impulsionnel d'horloge (Pc) est délivré.

4. Circuit de commande de niveau selon la revendication 1, dans lequel ledit moyen de commutation (20, 25), inclus dans le moyen générateur de tension impulsionnelle, comprend des premier (20) et second (25) dispositifs de commutation attaqués, de manière à être fermés et ouverts de façon alternée, par ledit signal modulé par largeur d'impulsion (Ps) obtenu du moyen de comparaison de niveau (12 à 18).

5. Circuit de commande de niveau selon la revendication 4, dans lequel ledit moyen générateur de tension impulsionnelle (20 à 25) comprend en outre un moyen d'inversion de polarité (24) pour inverser la polarité de ladite tension de commande (Vc) pour produire une tension de commande inversée (-Vc), et est agencé de sorte que ledit premier dispositif de commutation (20) est alimenté avec ladite tension de commande (Vc), que ledit second dispositif de commutation (25) est alimenté avec ladite tension de commande inversée (-Vc) obtenue à partir du moyen d'inversion de polarité (24), et dans lequel les sorties desdits premier et second dispositifs de commutation (20, 25) sont mélangées l'une avec l'autre pour produire ledit signal de tension impulsionnelle (Pi).

6. Circuit de commande de niveau selon la revendication 5, dans lequel ledit premier dispositif de commutation (20) comprend un premier transistor à effet de champ MOS (à semi-conducteurs isolés par oxyde métallique) (20a) dont le trajet drain-source est connecté de façon à être alimenté avec ladite tension de commande (Vc) et dont la grille est connectée audit moyen de comparaison de niveau (12 à 18), et dans lequel ledit second dispositif de commutation (25) comprend un deuxième transistor à effet de champ MOS (25a) dont le trajet drain-source est connecté de façon à être alimenté avec ladite tension de commande inversée (-Vc) et dont la grille est connectée audit moyen de comparaison de niveau (12 à 18).

7. Circuit de commande de niveau selon la revendication 6, dans lequel ledit premier dispositif de commutation (20) comprend en outre un troisième transistor à effet de champ MOS (20b), différent en type dudit premier transistor à effet de champ MOS (20a), et dont le trajet drain-source est connecté en parallèle au trajet drain-source dudit premier transistor à effet de champ et dont la grille est connectée audit moyen de comparaison de niveau (12 à 18), et dans lequel ledit second dispositif de commutation (25) comprend en outre un quatrième transistor à effet de champ MOS (25b), différent en type dudit deuxième transistor à effet de champ MOS (25a) et dont le trajet drain-source est connecté en parallèle au trajet drain-source dudit second transistor à effet de champ (25a) et dont la grille est connectée audit moyen de comparaison de niveau (12 à 18).

8. Circuit de commande de niveau selon la revendication 4, dans lequel ledit moyen générateur de tension impulsionnelle comprend en outre un moyen amplificateur opérationnel (44) possédant des première et seconde bornes d'entrée et une borne de sortie et qui est agencé de sorte que ledit premier dispositif de commutation (20) est connecté entre les première et seconde bornes d'entrée dudit moyen amplificateur opérationnel, que le second dispositif de commutation (25) est connecté entre la seconde borne d'entrée dudit moyen amplificateur opérationnel (44) et la masse, chacun de la première borne d'entrée dudit moyen amplificateur opérationnel (44) et dudit premier moyen de commutation (20) est alimenté avec le signal de commande (Vc), et la borne de sortie (Pi) dudit moyen amplificateur opérationnel alimente ledit moyen formant filtre passe-bas (31) avec ledit signal de tension impulsionnelle.

9. Circuit de commande de niveau selon la revendication 8, dans lequel ledit premier dispositif de commutation comprend un premier transistor à effet de champ MOS (20a) dont le trajet drain-source est connecté entre les première et seconde bornes d'entrée dudit moyen amplificateur opérationnel (44) et dont la grille est connectée audit moyen de comparaison de niveau (12 à 18) et dans lequel le second dispositif de commutation (25) comprend un second transistor à effet de champ MOS (25a) dont le trajet drain-source est connecté entre la seconde borne d'entrée dudit moyen amplificateur opérationnel (44) et la masse et dont la grille est connectée audit moyen de comparaison de niveau (12 à 18).

10. Circuit de commande de niveau selon la revendication 9, dans lequel ledit premier dispositif de commutation (20) comprend en outre un troisième transistor à effet de champ MOS (20b), différent en type dudit premier transistor à effet de champ MOS (20a), et dont le trajet drain-source est connecté en parallèle avec le trajet drain-source dudit premier transistor à effet de champ (20a) et dont la grille est connectée audit moyen de comparaison de niveau (12 à 18), et dans lequel ledit second dispositif de commutation (25) comprend en outre un quatrième transistor à effet de champ MOS (25b), différent en type dudit deuxième transistor à effet de champ MOS (25a), et dont le trajet drain-source est connecté en parallèle avec le trajet drain-source dudit deuxième transistor à effet de champ (25a) et dont la grille est connectée audit moyen de comparaison de niveau (12 à 18).

11. Circuit de commande de niveau selon la revendication 1, dans lequel chacun dudit moyen de comparaison de niveau (12 à 18), dudit moyen générateur de tension impulsionnelle (20 à 25) et dudit moyen formant filtre passe-bas (31) est constitué principalement de transistors à effet de champ MOS.

FIG. 1

$$I_E = I_S(e^{q \cdot V_{BE}/k \cdot T} - 1)$$

FIG. 2

$$I_D = a \cdot V_{GS}^2$$

FIG. 4A

FIG. 4B

FIG. 4C

FIG. 4D

FIG. 4E

FIG. 3

FIG. 5